Europäisches Patentamt

European Patent Office

Office européen des brevets

(11) Publication number : **0 087 700 B2**

# (12) NEW EUROPEAN PATENT SPECIFICATION

(45) Date of publication of the new patent specification :
22.04.92 Bulletin 92/17

(51) Int. Cl.⁵ : **H02H 3/38**

(21) Application number : 83101585.4

(22) Date of filing : 19.02.83

(54) **System for detecting a predetermined phase relation between two input electrical quantities detected from an electric power system.**

(30) Priority : **24.02.82 JP 30108/82**

(43) Date of publication of application :
**07.09.83 Bulletin 83/36**

(45) Publication of the grant of the patent :
**12.11.86 Bulletin 86/46**

(45) Mention of the opposition decision :
**22.04.92 Bulletin 92/17**

(84) Designated Contracting States :
**CH GB LI SE**

(56) References cited :
**CH-A- 421 254
DE-A- 3 031 539
DE-B- 1 588 481
US-A- 3 325 687**

(73) Proprietor : **MITSUBISHI DENKI KABUSHIKI KAISHA
2-3, Marunouchi 2-chome Chiyoda-ku
Tokyo 100 (JP)**

(72) Inventor : **Miyake, Yasuaki c/o Mitsubishi Denki K. K.
Power Ind. Syst. Center 1-2, Wadasakicho 1-chome
Hyogo-ku Kobe-shi Hyogo (JP)**
Inventor : **Isahaya, Keiji c/o Mitsubishi Denki K. K.
Power Ind. Syst. Center 1-2, Wadasakicho 1-chome
Hyogo-ku Kobe-shi Hyogo (JP)**
Inventor : **Nozawa, Teruo c/o Mitsubishi Denki K. K.
Power Ind. Syst. Center 1-2, Wadasakicho 1-chome
Hyogo-ku Kobe-shi Hyogo (JP)**
Inventor : **Matsuzaki, Tadashi c/o Mitsubishi Denki
K. K.
Power Ind. Syst. Center 1-2, Wadasakicho 1-chome
Hyogo-ku Kobe-shi Hyogo (JP)**
Inventor : **Kotani, Genzaburo c/o Mitsubishi Denki K.
K.
Power Ind. Syst. Center 1-2, Wadasakicho 1-chome
Hyogo-ku Kobe-shi Hyogo (JP)**
Inventor : **Sakai, Masatoshi c/o Mitsubishi Denki K.
K.
Power Ind. Syst. Center 1-2, Wadasakicho 1-chome
Hyogo-ku Kobe-shi Hyogo (JP)**

(74) Representative : **Eisenführ, Speiser & Strasse
Martinistrasse 24
W-2800 Bremen 1 (DE)**

EP 0 087 700 B2

## Description

The invention relates to a system for detecting a predetermined phase relation between two input electrical quantities detected from an electric power system, comprising square wave converters for deriving square wave signals having two logic levels from the input electrical quantities, a phase detection circuit outputting an output signal if said predetermined phase relation is detected-between said two input electrical quantities, and a waveform detection circuit for inhibiting the operation of said phase detection circuit, the waveform detection circuit receiving the square wave signal from one of the square wave converters and inhibiting the operation of the phase detection circuit only if a period during which the received square wave signal is at a constant logic level does not exceed a predetermined operation time. Such a system is known from DE-A-30 31 534.

The protective relaying equipment of an electric power system usually is provided with a phase detecting system for monitoring the phase relation between voltage and current detected from the power system. However, since various noises are contained in voltage and current signals derived from such voltage and current, it is necessary to extract their fundamental wave components by using filters for removal of such noises. But in the use of filters, their output signals also undergo transient changes due to transient change of the input voltage and current signals, which may satisfy a predetermined phase detecting condition and lead to malfunction of the phase detecting system. Thus, the conventional phase detecting system has the disadvantage that a sudden change in the input signal leads to malfunction of the system. Such a system is known from DE-B-15 88 481.

It is an object of the present invention to provide a system for detecting a predetermined phase relation between two input electrical quantities detected from an electric power system, which does not perform malfunction even if an input signal undergoes a sudden change, and which system is simple and safe in its operation.

According to the present invention, this object is solved by a system which is characterized in that said waveform detection circuit comprises a first differentiation circuit for detecting a rise of the square wave signal based on an input electrical quantity, a second differentiation circuit for detecting a fall of said square wave signal, a first timing circuit adapted to reset upon receipt of a pulse output from said first differentiation circuit and provide an output signal after the lapse of the predetermined operation time, a second timing circuit adapted to reset upon receipt of a pulse output from said second differentiation circuit and providing an output signal after the lapse of the predetermined operation time, a first NOR circuit which receives both said square wave signal and the output of said first timing circuit, and a second NOR circuit which receives both said square wave signal via an inverter and the output of said second timing circuit, and that said phase detection circuit comprises a coincidence circuit which provides an output signal only when the square wave signals based on the input electrical quantities are all "1" or "0", a timing circuit responsive to the output of said coincidence circuit after a certain time delay, and a time reset circuit which prolongs the output of said timing circuit by a predetermined period.

Other advantages of the present invention will become apparent from the following description taken in connection with the accompanying drawings wherein parts having the same function are indicated at the same reference numeral and wherein:

Fig. 1 is a block diagram of a conventional phase detecting system;

Fig. 2 is a vector diagram illustrating the response characteristics of the system shown in Fig. 1;

Fig. 3 illustrates waveforms of signals in the circuit of Fig. 1;

Fig. 4 illustrates waveforms of signals in the circuit of Fig. 1;

Fig. 5 is a block diagram of a phase detecting system embodying the invention;

Fig. 6 is a circuit diagram illustrating the details of a waveform detector shown in Fig. 5; and

Fig. 7 illustrates waveforms of signals in the circuit of Fig. 6.

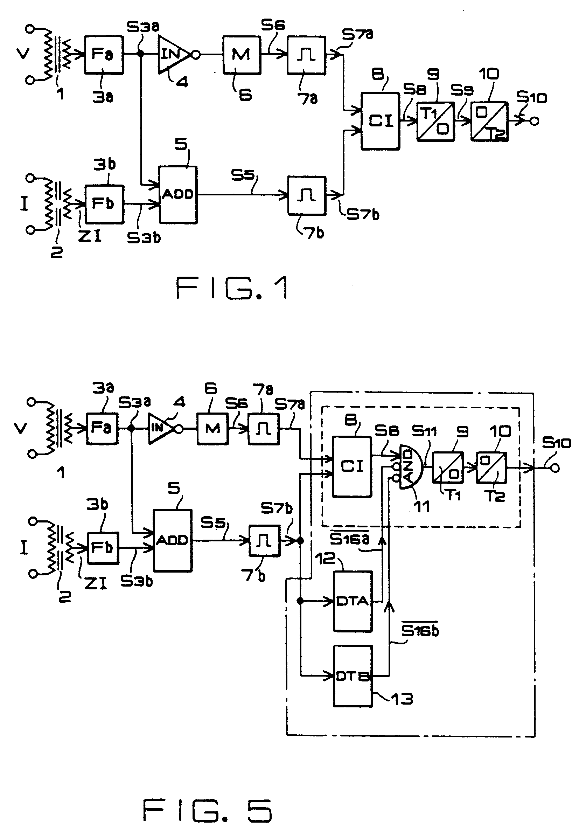

Referring to Fig. 1, which is a circuit diagram of a conventional system having the above-mentioned drawback, a voltage signal V with a period $T_o$ detected from for example, a portion within a section to be protected of a transmission line in an electric power system, and a current signal I associated with the voltage signal V, are respectively applied to a transformer 1 and a gap transformer 2 having predetermined impedance Z. The outputs of the transformers 1 and 2 are connected to an inverter (IN) 4 and an adder (ADD) 5 through band pass filter (Fa) 3a and (Fb) 3b which extract their fundamental wave component signals $S_{3a}$ and $S_{3b}$, respectively. The output of the inverter 4 is fed to a signal memory circuit (M) 6, which functions to hold the previous input although a sudden drop of input to zero may occur and which outputs a voltage signal $S_6$ (= -V). The signal $S_6$ is converted to a square wave signal $S_{7a}$ by a square wave converter 7a, and the square wave signal $S_{7a}$ is fed to a coincidence detector (CI) 8.

The adder 5 adds the two input signals $S_{3a}$ and $S_{3b}$ and provides a composite signal $S_5$ (= V-ZI), which is converted to a square wave signal $S_{7b}$ by a square wave converter 7b and then fed to the detector 8. The detector 8, which comprises an exclusive OR gate and an inverter, outputs a coincidence detection signal $S_9$ at a high level during the period of coincidence in logic level of its two inputs. If the high level of the

signal $S_8$ is continued for longer than time $T_1$, a timer 9, which receives the signal $S_8$, outputs a time delay signal $S_9$ at a high level, and in response thereto a timer 10 outputs a phase detection signal $S_{10}$ at a high level for time $T_2$. The high level of the signal $S_{10}$ shows the existence of a phase coincidence over a predetermined time period between voltage and current signals V and IZ.

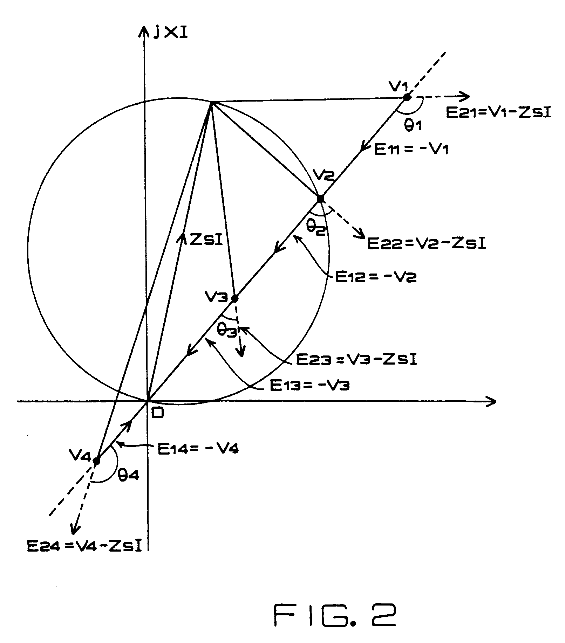

Fig. 2 shows a vector diagram (mho phase characteristics) of the distance relay illustrated in Fig. 1. The range wherein an angle $\theta$ between vector $E_1 = -V$ and vector $E_2 = V-Zsl$ is smaller than $\pm 90°$ corresponds to an operation region of a phase detection circuit comprising a detector 8 and timers 9 and 10, so that there is obtained a circular characteristic wherein the operation region is with vector $E_1$ entering a circle having a diameter of vector Zsl. For example, (i) in a forward external fault (fault voltage $V_1$), a phase angle $\theta_1$ between vectors $E_{11}$ and $E_{21}$ becomes larger than 90°, so that the phase detection circuit does not operate, (ii) in a limit (faultpoint fault voltage $V_2$), a phase angle $\theta_2$ between vectors $E_{12}$ and $E_{22}$ becomes equal to 9O° and thus a limit is reached, (iii) in an internal fault (fault voltage $V_3$), a phase angle $\theta_3$, between vectors $E_{13}$ and $E_{23}$, becomes smaller than 90°, so that the phase detection circuit operates, and (iv) in an external fault at a nearby backward point (fault voltage $V_4 \doteqdot 0$), a phase angle $\theta_4$ between vectors $E_{14}$ and $E_{24}$ becomes larger than 90° ($\theta_4 \doteqdot 180°$), so that the phase detection circuit does not operate.

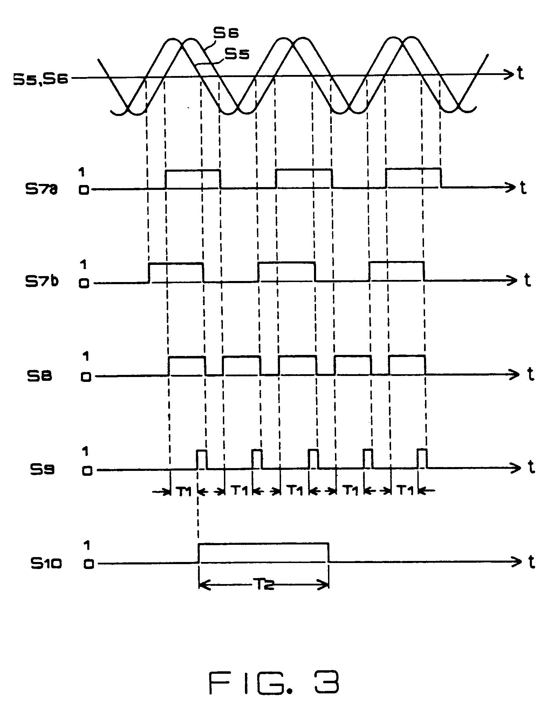

The setting impedance Zs is set as follows with respect to the impedance $Z_L$ within the protecting section: $Zs = KZ_L$, wherein K is a proportional constant of $0 < K < 1$. Fig. 3 shows signals $S_{7a}$, $S_{7b}$, $S_8$, $S_9$ and $S_{10}$ provided from square wave circuits 7a and 7b, detector 8 and timers 9 and 10, respectively, in the case of an internal fault (fault voltage $V_3$). A coincidence signal $S_8$ determined from square wave signals $S_{7a}$ and $S_{7b}$ for composite amounts $E_1$ and $E_2$ is compared with time $T_1$ ($= T_0/4$), and when the pulse width of $S_8$ is larger than $T_1$, there is obtained an operation signal $S_9$, which in turn is prolonged by time $T_2$ to provide a continued signal $S_{10}$. With this final signal $S_{10}$ the distance relay operates.

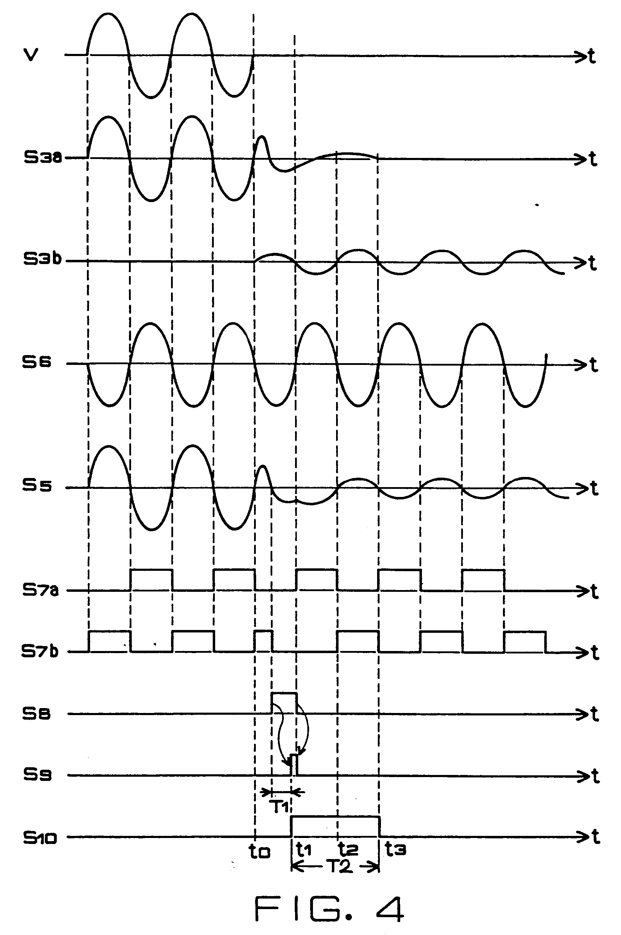

But in the event of a sudden change in the input electrical quantities of the filters 3a and 3b, there occurs a transient phenomenon in which the memory characteristics of the filters allow the electrical quantities before the sudden change to remain at the outputs while damping thereby dulling the rising and falling characteristics of the filter, for example, as shown in Fig. 4 in the case of an external fault at a nearly backward point (fault voltage $V_4 \doteqdot 0$, phase angle $\theta_4 \doteqdot 180$).

Referring now to Fig. 4, there is shown waveforms of signals in the circuit of Fig. 1 with respect to periods before and after time $t_0$ at which there occurs a fault outside the section to be protected of a transmission line. In the event a fault of the transmission line should occur at time $t_0$, causing the voltage signal V to disappear suddenly, the signal $S_{3a}$ from the filter 3a undergoes a transient change and the resultant vibration continues until time $t_3$. Consequently, the waveform ofthe signal $S_5$ from the adder 5 is distorted and a pulse shorter than normal one is provided from the converter 7b, resulting in that signal $S_8$ at a high level for holding more than $T_1$ is provided from the detector 8. With the signal $S_8$ the timer 9 is triggered and causes the timer 10 to provide signal $S_{10}$ at a high level. After time $t_3$, since the transient change at the filter 3a is settled, the signal $S_{7b}$ from the converter 7b becomes normal and the detector 8 never detects a phase coincidence.

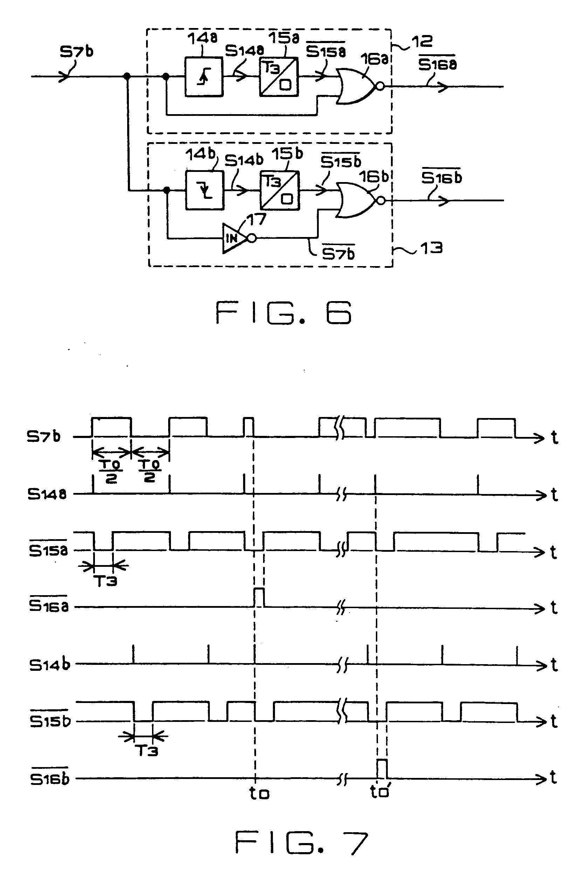

Referring to Fig. 5, there is shown a block diagram of a phase detecting system according to a preferred embodiment of the present invention, in which, as previously noted, voltage signal V, after input to the transformer 1, is fed to the detector 8 via filter 3a, inverter 4, memory 6 and converter 7a, while voltage signal ZI is fed via filter 3b, adder 5 and converter 7b to the detector 8. Signal $S_8$ from the detector 8 is fed to a first input terminal of an AND gate 11. Signal $S_{7b}$ from the converter 7b is fed also to waveform detectors (DTA) 12 and (DTB) 13.

Referring now to Fig. 6, there is shown a circuit diagram illustrating the details of the waveform detectors 12 and 13, in which signal $S_{7b}$ is fed to differentiators 14a and 14b, the differentiator 14a detects a rising edge of the signal and produces a differentiated pulse signal $S_{14a}$ while the differentiator 14b detects a falling edge of the signal and produces a differentiated pulse signal $S_{14b}$. The signal $S_{14a}$ is fed to a timer 15a, and when it becomes high, the timer 15a outputs a time delay signal $\overline{S}_{15a}$ at a low level during time

$$T_3 = (\frac{T_0}{4} + \alpha,$$

$\alpha$ being a minimum allowable value) and then changes to a high state until input of the next pulse signal. A NOR gate 16a takes a high logic OR between signals $\overline{S}_{15a}$ and $S_{7b}$ and outputs an abnormal waveform signal $\overline{S}_{16a}$.

The signal $S_{14b}$ is fed to a timer 15b, which, when the signal becomes high, outputs a time delay signal $\overline{S}_{15b}$ at a low level during time $T_3$, similarly to the timer 15a. An NOR gate 16b takes a high logic OR between the signal $\overline{S}_{15b}$ and a signal $\overline{S}_{7b}$ resulting from inversion of the signal $S_{7b}$ by an inverter (IN) 17, and outputs an abnormal waveform signal $\overline{S}_{16b}$.

The signals $\overline{S}_{16a}$ and $\overline{S}_{16b}$ are fed to second and third low active input terminals of the AND gate 11 (Fig. 5) and ANDed with signal $S_8$ fed to a first high active input terminal from the detector 8. Signal $S_{11}$ from the AND gate 11 is fed to the timer 9, and the timer 10 cascaded to the timer 9 produces signal $S_{10}$

as a final output.

The operation of the circuit shown in Fig. 5 will now be described. During the period free from fault of the transmission line, namely, before time $t_o$, the signal $S_{7b}$ from the converter 7b becomes a regular signal which repeats high and low with a pulse width of

$$\frac{T_o}{2}$$

as shown in Fig. 7, and at its leading edge the differentiator 14a produces a pulse signal $S_{14a}$. When the signal $S_{14a}$ becomes high, the timer 15a outputs signal $\overline{S}_{15a}$ at a low level during time $T_3$. In this case, during the low level period of the signal $\overline{S}_{15a}$, the signal $S_{7b}$ is kept high, so that the NOR gate 16a maintains signal $\overline{S}_{16a}$ at a low level. Likewise, the differentiator 14b produces a pulse signal $S_{14b}$ at the trailing edge of the signal $S_{7b}$ to trigger the timer 15b, which in turn outputs signal $\overline{S}_{15b}$ at a low level during time $T_3$. During the low level period of the signal $\overline{S}_{15b}$ the signal $\overline{S}_{7b}$ is kept high, so that the NOR gate 16b also maintains signal $\overline{S}_{16b}$ at a low level.

However, at time to, the signal $S_{7b}$ drops without keeping high during

$$\frac{T_o}{2}$$

due to a fault occurs outside the section to be protected of the transmission line, so that the two signal inputs to the NOR gate 16a both become low, the gate 16a outputs signal $\overline{S}_{16a}$ at a high level and disables the AND gate 11 to maintain signal $S_{11}$ at a low level. Consequently, the timers 9 and 10 are not turned on, and the signal $S_{10}$ is kept inactive. That is, the system is free from malfunction even when a transient disorder of waveform occurs in the signal $S_{3a}$ from filter 3a. At time $t_o{}'$, the signal $S_{7b}$ erroneously becomes low due to the trouble of the transmission line. In the case, as will be apparent from the foregoing description taken in connection with time $t_o$, the two signal inputs to the NOR gate 16b both become low and the gate 16b outputs signal $\overline{S}_{16b}$ at a high level, so that the AND gate 11 is disabled and the timer 10 does not output signal $S_{10}$. That is, the system does not respond erroneously even in the presence of such a transient disorder of waveform that causes the coincidence detector (CI) 8 to enable the signal $S_8$.

## Claims

1. A system for detecting a predetermined phase relation between two input electrical quantities (S5, S6) detected from an electric power system, comprising square wave converters (7a, 7b) for deriving square wave signals (S7a, S7b) having two logic levels from the input electrical quantities, a phase detection circuit (8, 9, 10, 11) outputting an output signal (S10) if said predetermined phase relation is detected between said two input electrical quantities (S5, S6), and a waveform detection circuit (12, 13) for inhibiting the operation of said phase detection circuit (8, 9, 10, 11), the waveform detection circuit (12, 13) receiving the square wave signal (S7b) from one (7b) of the square wave converters and inhibiting the operation of the phase detection circuit (8, 9, 10, 11) only if a period during which the received square wave signal (S7b) is at a constant logic level does not exceed a predetermined operation time (T3), characterized in that said waveform detection circuit (12, 13) comprises a first differentiation circuit (14a) for detecting a rise of the square wave signal (S7b) based on an input electrical quantity, a second differentiation circuit (14b) for detecting a fall of said square wave signal (S7b), a first timing circuit (15a) adapted to reset upon receipt of a pulse output from said first differentiation circuit (14a) and provide an output signal after the lapse of the predetermined operation time (T3), a second timing circuit (15b) adapted to reset upon receipt of a pulse output from said second differentiation circuit (14b) and providing an output signal after the lapse of the predetermined operation time (T3), a first NOR circuit (16a) which receives both said square wave signal (S7b) and the output of said first timing circuit (15a), and a second NOR circuit (16b) which receives both said square wave signal (S7b) via an inverter (17) and the output of said second timing circuit (15b), and that said phase detection circuit (8, 9, 10, 11) comprises a coincidence circuit (8) which provides an output signal only when the square wave signals (S 7a, S 7b) based on the input electrical quantities are all "1" or "0", a timing circuit (9) responsive to the output of said coincidence circuit (8) after a certain time delay (T1), and a time reset circuit (10) which prolongs the output of said timing circuit (9) by a predetermined period (T2).

2. A system according to claim 1, wherein the operation time (T3) of each of said first and second timing circuits (15a, 15b) is longer than one-fourth of a period of an input electrical quantity.

3. A system according to claim 1, wherein said certain time delay (T1) of said timing circuit (9) is one-fourth to one-third of a period of an input electrical quantity.

4. A system according to claim 1, wherein the output signals ($\overline{S}_{16a}$, $\overline{S}_{16b}$) of the waveform detection circuit (12, 13) control an AND gate (11) for inhibiting the output of said phase detection circuit (8, 9, 10, 11).

## Patentansprüche

1. System zum Erfassen einer vorbestimmten Phasenverschiebung zwischen zwei in einem elektrischen EnergieSystem erfaßten elektrischen Größen (S5, S6), mit Rechtecksignalwandlern (7a, 7b) zum Ableiten von zwei logische Pegel aufweisenden Rechtecksignalen (S7a, S7b) aus den elektrischen Größen, mit einer Phasendetektorschaltung (8, 9, 10, 11) zur Ausgabe eines Ausgangssignals (S10), wenn die vorbestimmte Phasenverschiebung zwischen den beiden elektrischen Größen (S5, S6) vorliegt, und mit einer Wellenformdetektorschaltung (12, 13) zum Sperren der Funktion der Phasendetektorschaltung (8, 9, 10, 11), wobei der Wellenformdetektorschaltung (12, 13) das Rechtecksignal (S7b) eines (7b) der Rechtecksignalwandler zuführbar ist und die Funktion der Phasendetektorschaltung (8, 9, 10, 11) nur dann sperrt, wenn der Zeitraum, in dem das Rechtecksignal (S7b) einen konstanten Logikpegel annimmt, eine vorbestimmte Betätigungszeit (T3) nicht überschreitet, dadurch gekennzeichnet, daß die Wellenformdetektorschaltung (12, 13) gekennzeichnet ist durch ein erstes Differenzierglied (14a) zum Erfassen eines Anstiegs des Rechtecksignals (S7b) einer elektrischen Größe; ein zweites Differenzierglied (14b) zum Erfassen eines Abfalls des Rechtecksignals (S7b) ; ein erstes Zeitglied (15a), das beim Empfang eines Ausgangsimpulses aus dem ersten Differenzierglied (14a) zurückgestellt wird und ein Ausgangssignal nach Ablauf der vorbestimmten Betätigungszeit (T3) liefert; ein zweites Zeitglied (15b), das beim Empfang eines Ausgangsimpulses aus dem zweiten Differenzierglied (14b) zurückgestellt wird und ein Ausgangssignal nach Ablauf der vorbestimmten Betätigungszeit (T3) liefert; eine erste NOR-Schaltung (16a), der das Rechtecksignal (S7b) und das Ausgangssignal des ersten Zeitgliedes (15a) zugeführt wird; und eine zweite NOR-Schaltung (16b), der das Rechtecksignal (S7b) über einen Inverter (17) und das Ausgangssignal des zweiten Zeitgliedes (15b) zugeführt wird, und daß die Phasendetektorschaltung (8, 9, 10, 11) eine Koinzidenzschaltung (8) enthält, die nur dann ein Ausgangssignal liefert, wenn die aus den elektrischen Größen abgeleiteten Rechtecksignale (S7a, S7b) alle den logischen Wert "1" oder "0" aufweisen; ein auf das Ausgangssignal der Koinzidenzschaltung (8) mit einer bestimmten Zeitverzögerung (T1) ansprechendes Zeitglied (9) sowie eine Zeitrückstellschaltung (10), die das Ausgangssignal des Zeitgliedes (9) um einen vorbestimmten Zeitraum verlängert.

2. System nach Anspruch 1, dadurch gekennzeichnet, daß die Betätigungszeit (T3) jedes der beiden Zeitglieder (15a, 15b) länger ist als 1/4 der Periode der elektrischen Größen.

3. System nach Anspruch 1, dadurch gekennzeichnet, daß die bestimmte Zeitverzögerung (T1) des Zeitgliedes (9) 1/4 bis 1/3 der Periode der elektrischen Größen beträgt.

4. System nach Anspruch 1, dadurch gekennzeichnet, daß die Ausgangssignale ($\overline{S16a}$, $\overline{S16b}$) der Wellenformdetektorschaltung (12, 13) eine UNDSchaltung (11) zum Sperren des Auganges der Phasendetektorschaltung (8, 9, 10, 11) steuern.

**Revendications**

1. Système de détection d'une relation de phase prédéterminée entre deux grandeurs électriques (S5, S6) appliquées sur son entrée et détectées dans un système électrique de puissance, comprenant des convertisseurs de signaux en ondes en créneaux (7a, 7b) destinés à produire des signaux d'ondes en créneaux (S7a, S7b), possédant deux niveaux logiques à partir des grandeurs électriques d'entrée, un circuit de détection de phase (8, 9, 10, 11) délivrant un signal de sortie (S10) si ladite relation de phase prédéterminée est detectée entre lesdites deux grandeurs électriques d'entrée (S5, S6) et un circuit de détection de forme d'onde (12, 13) destinée à bloquer l'action dudit circuit de détection de phase (8, 9, 10, 11), le circuit de détection de forme d'onde (12, 13) recevant le signal d'onde en créneaux (S7b) de l'un (7b) des convertisseurs de signaux en ondes en créneaux et bloquant l'action du circuit de détection de phase (8, 9, 10, 11) uniquement si une période de temps, au cours de laquelle le signal d'onde en créneaux reçu (S7b) est à un niveau logique constant, ne dépasse pas un intervalle de temps de fonctionnement prédéterminée (T3), caractérisé en ce que ledit circuit de détection de forme d'onde (12, 13) comprend un premier circuit différentiateur (14a) destiné à détecter un flanc de montée du signal d'onde en créneaux (S7b) fonction d'une grandeur électrique d'entrée, und deuxième circuit différentiateur (14b) destiné à détecter un flanc de descente dudit signal d'onde en créneaux (S7b), un premier circuit de temporisation (15a) conçu pour être replacé dans l'état initial à réception d'une impulsion de sortie dudit premier circuit différentiateur (14a) et pour fournir un signal de sortie après écoulement de l'intervalle de temps de fonctionnement prédéterminé (T3), und deuxième circuit de temporisation (15b) conçu pour être replacé dans l'etat initial à réception d'une impulsion de sortie dudit deuxième circuit différentiateur (14b) et fournissant un signal de sortie après écoulement de l'intervalle de temps de fonctionnement prédéterminé (T3), un premier circuit NON-OU (16a) qui reçoit à la fois ledit signal d'onde en créneaux (S7b) et le signal de sortie dudit premier circuit de temporisation (15a), et un deuxième circuit NON-OU (16b) qui reçoit à la fois ledit signal d'onde en créneaux (S7b) via un inverseur (17) et le signal de sortie dudit deuxième circuit de temporisation (15b), et que ledit phase détection circuit (8, 9, 10, 11) comprend un circuit de coincidence (8) que ne délivre un signal de sortie lorsque les signaux d'ondes en créneaux (S7a, S7b), fonction des grandeurs électriques d'entrée, sont tous au "1" ou au "0", un circuit de temporisation (9) sensible au signal de sortie dudit circuit de coincidence (8) après écoulement d'un délai de temps prédéterminé (T1), et un circuit de remise à l'état initial de la temporisation (10) qui allonge le signal de sortie dudit circuit de temporisation (9) sur une periode de temps prédéterminée (T2).

2. Système selon la revendication 1, dans lequel l'intervalle de temps de fonctionnement (T3) de chacun desdits premier et deuxième circuits de temporisation (15a, 15b) est d'une longueur supérieure au quart d'une periode d'une grandeur électrique d'entrée.

3. Système selon la revendication 1, dans lequel ledit délai de temps (T1) dudit circuit de temporisation (9) représente de un quart à un tiers d'une période d'une grandeur électrique d'entrée.

4. Système selon la revendication 1, dans lequel les signaux de sortie (S16a, S16b) du circuit de détection de forme d'onde (12, 13) pilote une porte ET (11) pour supprimer le signal de sortie dudit circuit de détection de phase (8, 9, 10, 11).

FIG. 1

FIG. 5

FIG. 2

FIG. 3

FIG. 4

# FIG. 6

# FIG. 7